# EUROPEAN PATENT SPECIFICATION

(11) **EP 0 961 129 B1**
(45) Date of publication and mention of the grant of the patent: **31.08.2005**
(21) Application number: 99201733.5
(22) Date of filing: 31.05.1999
(51) Int. Cl.: G01R 31/327, G01R 31/28

(54) **Test circuit with time-limited fault current for a protection device**
Schaltung zum Prüfen einer zeitlich begrenzten Fehlerstromschutzvorrichtung
Circuit de test pour un dispositif de protection avec courant de defaut temporaire

(30) Priority: 29.05.1998 NL 1009293
(43) Date of publication of application: 01.12.1999
(73) Proprietor: Eaton Electric N.V., 7559 SC Hengelo (NL)
(72) Inventor: Niehoff, Ronaldus Hendrikus Maria, 7577 MB Oldenzaal (NL); Limon, Edward Stanley, 7556 ML Hengelo (NL)
(74) Representative: van Westenbrugge, Andries

(56) References cited:
- WO-A-84/01033
- DE-A- 3 151 261
- GB-A- 2 072 861
- GB-A- 2 305 315

## Description

The invention relates to a test circuit for testing a fault current protection device, comprising a test switch and a fault current simulation circuit, which can be switched on by means of the test switch and in which a test resistor is incorporated, and a timing circuit, which switches off the fault current simulation circuit at the end of a predetermined time after the fault current simulation circuit has been switched on.

A test circuit of this nature is known from British patent application 2,072,861. The test switch, which is to be operated by an operator, triggers a time circuit, at the output of which a time-limited control current is formed, which control current is fed to a relay. After the test switch has been actuated, the relay therefore remains energized for a predetermined time. A contact associated with this relay is connected in series with a test resistor, which series circuit is incorporated in the fault current simulation circuit.

Furthermore, international patent application WO 84/01033 describes a test circuit for a fault current protection device, in which the time circuit is formed by a second relay with pull-in delay for switching off the test circuit, in particular the fault current simulation circuit.

The object of the invention is to provide a circuit of the type mentioned in the preamble in which the testing facility can be incorporated in the fault current protection device, while the switch-off time of the switch can be tested accurately.

According to the invention, this object is achieved by the fact that the switching path of a semiconductor switch, which is triggered by the test switch and directly by an electronical time-control circuit, is incorporated in the fault current simulation circuit.

From De 31 51 261 A a testing circuit having semiconductor switches is known. This testing circuit is separated from the protection device.

Embodiments which are preferably used are described in the subclaims.

The invention will be explained in more detail below with reference to the drawings, in which:
Fig. 1 illustrates a first embodiment of the test circuit according to the invention;
Fig. 2 shows another embodiment of the test circuit according to the invention;
Fig. 3 shows yet another embodiment of the test circuit according to the invention; and
Fig. 4 shows various waveforms in the embodiment in accordance with Fig. 3.

The test circuit according to the invention will be explained with reference to its use in earth leakage protection devices. However, the principle of time-limited testing which is employed in the test circuit according to the invention can also be used for overcurrent protection devices where it is desired to carry out testing with a current which is lower than the short-circuit current and the overcurrent protection device must respond within a certain time.

The test circuit comprises a test switch which can be operated by an operator in order to switch on a fault current simulation circuit. This circuit is switched on by means of a semiconductor switch, the switching path of which is connected in series with a test resistor, which series circuit is incorporated in the fault current simulation circuit.

An earth-leakage detection circuit can be tested using a fault current from phase to earth instead of testing between phase and neutral or between two phases. This has the advantage of testing not only the earth-fault detection circuit and the earth-leakage switch which it controls, but also the impedance of the earth line.

In addition, in the case of a neutral-to-earth fault, the earth-leakage switch which is controlled by the earth-fault detection circuit becomes insensitive to phase-earth faults which occur. This neutral-to-earth fault is also noted when testing from phase to earth, since the earth-leakage switch then does not respond. In the case of the earth-leakage switches of the applicant, an earth connection is generally already present, making it easy to test to earth.

It is advantageous to connect the fault current simulation circuit according to the invention between a phase and earth. The semiconductor switch is switched on as a result of actuation of the test switch, so that a fault current which is determined by the measuring resistance and the transition resistance of the semiconductor switch is generated. This fault current causes the earth-leakage switch to respond if the latter is functioning correctly. The test switch is preferably connected between the phase and the fault current simulation circuit, so that electrical isolation within a non-actuated test circuit is automatically produced and the test circuit is connected through to earth potential when the test button is not depressed. The test switch may also be incorporated between earth and fault current simulator, but in this case the test circuit when not in use is connected to phase potential.

Furthermore, the test circuit includes a time-control circuit which switches off the semiconductor switch after a predetermined time since it had been switched on. As a result, the test time is limited irrespective of the operator, so that furthermore dissipation of energy in the switch is limited and any faults in the time control of the earth-leakage switch can come to light, since an earth-leakage switch must switch off within a predetermined time, depending on the earth-leakage current.

Limiting the test duration to, for example, 300 ms (maximum trip time at the nominal fault current) therefore has the following advantages:
1. The test resistor can no longer be blown in the event of the earth-leakage switch sticking or neutral-to-earth fault or in the event of an excessive impedance of the earth line.
2. The earth-leakage switch is tested in accordance with the standard.
3. If the test current is set to approximately the nominal fault current (rather than a value of at most 2.5 x the nominal fault current, as with conventional types) by means of the test resistor, the obligatory testing in accordance with NEN 3140 can be carried out by operators who are not skilled electrical technicians.

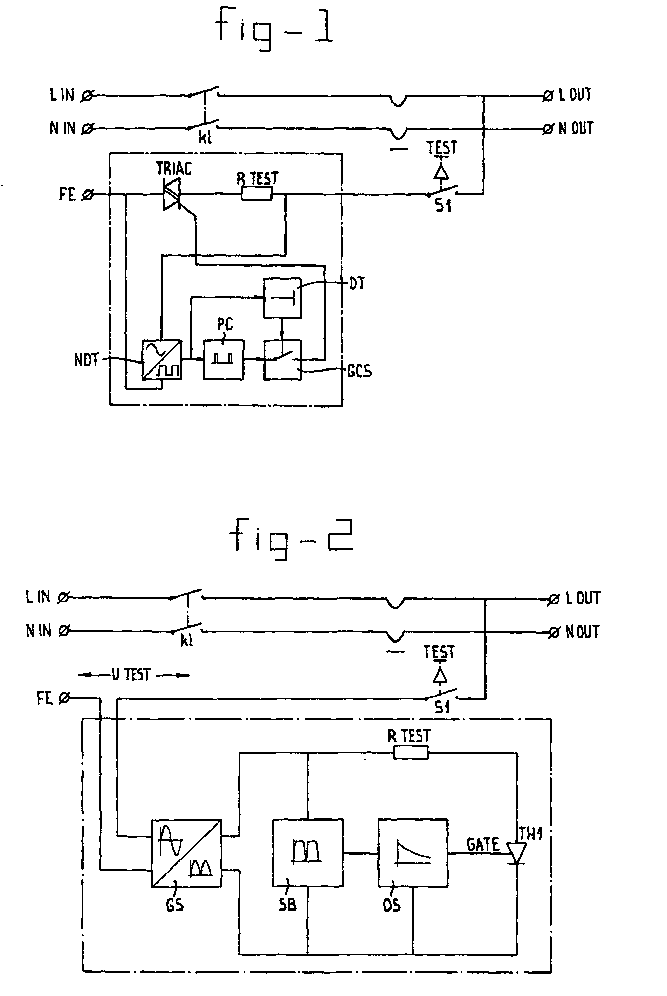

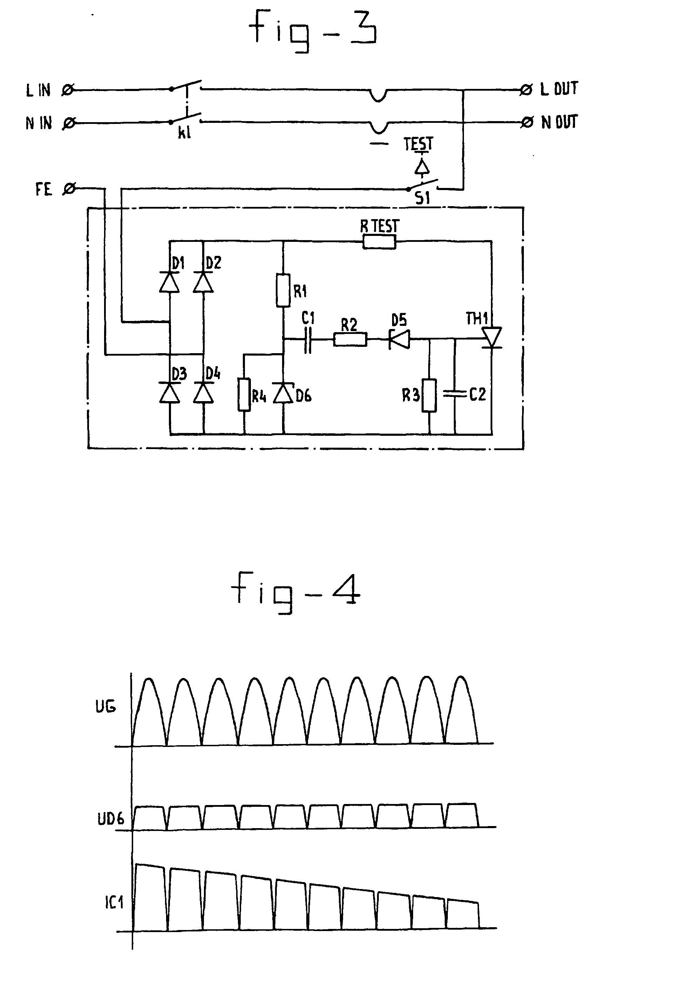

Figs. 1 and 2 illustrate the simplest embodiments of the test switch with limited test duration. They are in principle independent of the testing to earth and can also be used in the present-day test method, in which a fault current is simulated in the detection circuit by means of a resistor and a test switch between phase and neutral. However, in this case the added value is less, since it is precisely when testing to earth that there is a much greater risk of the earth-leakage switch not responding for the reasons given above.

In the embodiment shown in Fig. 1, the semiconductor switch comprises a triac. The switching path of this triac is connected in series with a test resistor Rtest and the test switch S1. This series circuit is incorporated in the fault current simulation circuit which is connected between the phase L IN-L OUT and a functional earth terminal FE. The gate of the triac is controlled by the gate-control switch GCS. The gate-control switch is controlled, on the one hand, by a zero-crossing detector NDT via a pulse former PG. The zero-crossing detector NDT is connected across the series circuit comprising test resistor Rtest and triac.

On the other hand, the gate-control switch GCS is controlled by a delay-time circuit, which in this embodiment is a monostable multivibrator DT which cannot be retriggered and which takes care of the time-limited switching off of the gate-control switch GCS. The delay-time circuit is triggered by the zero-crossing detector.

As soon as the circuit shown in Fig. 1 is fed with current as a result of test switch S1 being switched on, the zero crossings of the voltage Utest are detected by zero-crossing detector NDT. The pulse former PG makes them into pulses, with which the triac can be switched. The monostable multivibrator DT which cannot be retriggered produces one pulse, the duration of which is equal to the desired test duration, after detection of the first zero crossing of the voltage Utest. By means of the gate-control switch GCS, the output of DT switches the suitably formed pulses of the zero-crossing detector, thus triggering the triac. The result is that the triac is pulsed only for one connected period.

When the test switch is actuated, the triac is triggered virtually immediately via the gate-control switch GCS. As a result of the triac being switched on, a test current of U/Rtest is produced. If the earth-leakage switch responds, the protected circuit is disconnected. However, if the earth-leakage switch does not respond, for example as a result of a defective mechanism or as a result of neutral-to-earth short, the triac is switched off, for example after 300 ms. This time limitation is made possible by the use of the delay-time circuit DT.

The test circuit may be accommodated on one (ceramic) support and has two terminals. This test circuit is then entirely independent of the earth fault electronics and can also be used for all types of possible earth fault electronics. The test switch S1 itself provides the electrical isolation.

In the embodiment shown in Fig. 2, the semiconductor switch used is a thyristor TH1. In this case, the location of the test resistor Rtest is selected in such a manner that when the thyristor is activated sufficient voltage remains for the trigger circuit of this thyristor.

The embodiment in accordance with Fig. 2 operates as follows.
When test switch S1 is closed, the voltage between FE and L OUT passes to a rectifier circuit GS. A voltage limiter SB limits the voltage from the rectifier circuit GS, so that even with varying voltage Utest it is possible to produce pulses of more or less equal amplitudes, which are used to trigger a trigger circuit OS for the thyristor. This trigger circuit OS converts the incoming pulse train containing equal pulses into a different pulse train, the amplitude of which decreases in time. The first pulses will constantly trigger the thyristor, until the pulses become so small that they are no longer able to trigger the thyristor.

In accordance with Fig. 3, the thyristor TH1 is incorporated in the fault current simulation circuit via a rectifier circuit, in this case a full-wave (Graetz) rectifier comprising the diodes D1-D4. The input of this full-wave rectifier D1-D4 is connected in series with the test switch S1. Here too, the fault current simulation circuit is connected between phase and earth. The series circuit comprising the test resistor Rtest and the anode-cathode path of the thyristor is connected to the output of the full-wave rectifier. The trigger circuit of the thyristor TH1 consists of a series circuit comprising a first resistor R1, a first capacitor C1, a second resistor R2, a first zener diode D5 and a parallel circuit comprising a third resistor R3 and second capacitor C2, which series circuit is connected to the output of the full-wave rectifier. The trigger circuit furthermore comprises a parallel circuit comprising a fourth resistor R4 and a second zener diode D6, which parallel circuit is connected between the connection point of the first resistor R1 to the first capacitor C1 and the output terminal of the full-wave rectifier which is not connected to the first resistor R1. The zener voltage of the zener diode D5 is, for example, 12 volts, and the zener voltage of the zener diode D6 is, for example, 33 volts. When the switch S1 is switched on, the thyristor is triggered virtually immediately. As a result, a test current of approx. U/Rtest is produced. If the earth-leakage switch responds, the protected circuit is disconnected. However, if the earth-leakage switch does not respond (for example as a result of a defective mechanism or as a result of neutral-to-earth fault), the thyristor is switched off after a predetermined time (for example 300 ms).

A sine wave UG which has undergone full-wave rectification (cf. Fig. 4), which is required since thyristor TH1 can only conduct in one direction, is obtained by means of the full-wave rectifier D1-D4. Rtest is positioned downstream of the full-wave rectifier, because sufficient voltage then remains for the trigger circuit in the event of TH1 conducting. In this way, a sinusoidal fault current is also obtained.

The gate-triggering circuit ensures that TH1 continues to conduct until the total test time has been reached. This takes place in the following way:

The thyristor TH1 is made to conduct via components R1, C1, R2 and D5. The current IC1 through this network is illustrated at the bottom of Fig. 4. This current slowly decreases with time constant C1*R2, since capacitor C1 is being charged.

The thyristor TH1 is thus made to conduct with a decreasing gate current until the latter falls below the triggering current. TH1 then ceases conducting. If the test button is then released, C1 can be discharged via network R4, R2, D5 and R3. C2 is used for radio-frequency decoupling of the gate-cathode junction of TH1. D5 is used to create a threshold, so that in the event of possible interference pulses on node R1, C1, D6 and R4 these pulses are not transmitted directly to the thyristor. R3 also serves to dissipate the leakage current from the zener diode D5, so that D5 begins to conduct at a defined zener voltage. D6 limits the voltage UD6 at node R1, C1, D6, R4, so that the circuit is less dependent on the amplitude of the mains voltage. The voltage UD6 is shown in the centre of Fig. 4.

For this embodiment too, this test circuit can be accommodated on one (ceramic) support and has two terminals. The test circuits in accordance with Figs. 2 and 3 are also entirely independent of the earth-leakage electronics, while the test button itself provides electrical isolation.

It should be noted that the test switch S1 must remain depressed during testing. Obviously, this can also be achieved in a different way by connecting the test switch S1 to the circuit as a trigger input, but in this case the electrical isolation is no longer present without further measures.

The two circuits are dimensioned in such a way that below a defined operating voltage the triac or thyristor no longer conducts. Up to this minimum value of the operating voltage, the test time of the circuits remains constant.

If a test resistor which, at the nominal mains voltage, produces approximately the nominal fault current is selected, a lower limit of the operating voltage of up to approximately 70% of the nominal mains voltage is selected, since below this mains voltage the fault current produced will be too low for the earth fault detection circuit to be able to respond.

According to the product standard for earth fault detection circuits (IEC 1008/1009), the test resistor must produce at most 2.5 times the nominal fault current at nominal mains voltage. It is obvious that the lower limit of the operating voltage of the circuits which limit the test time is then selected to be much lower; it may be, for example, as low as 30% of the mains voltage. This is because the response threshold of the earth fault detection circuits generally lies at approx. 0.75 times the nominal response threshold. If the test resistor is dimensioned to produce 2.5 times the nominal fault current (IΔn), the earth fault detection circuit can still just respond at 30% of the nominal mains voltage ((1/2.5)*0.75=0.3).

In a TT distribution network, for example, the earthing resistance must be at most 50 V/IΔn; for an IΔn of 30 mA, the maximum earthing resistance is therefore 1667 Ω. In the event of a faulty (excessive) earthing resistance R_{E}, the voltage falls across the circuit limiting the test time. If this voltage becomes so low that at the resistance value of Rtest selected there is no longer sufficient fault current, the earth fault detection circuit will not respond. The operating voltage of the circuit limiting the test time has to be matched to this lower limit of the mains voltage. At even lower mains voltages, the circuit limiting the test time can remain switched off, so that the operator notices that the earth fault detection circuit is not responding and therefore has a fault indication.

To summarize, it can be stated that the test comprises actuation of the test switch S1, after which the earth-leakage switch should trip. If this does not take place, something is wrong.

## Claims

1. Protection device provided with a test circuit for testing a fault current, comprising a test switch (S1) and a fault current simulation circuit, which can be switched on by means of the test switch and in which a test resistor (R TEST) is incorporated, and a timing circuit (DT; OS; C1, R2), which switches off the fault current simulation circuit at the end of a predetermined time after the fault current simulation circuit had been switched on, **characterized in that** the switching path of a semiconductor switch (TRIAC; TH1), which is triggered by the test switch (S1) and directly by an electronical time-control circuit (DT; OS; C1, R2) is incorporated in the fault current simulation circuit.

2. Protection device according to Claim 1, **characterized in that** the test switch (S1) is incorporated in the fault current simulation circuit adjacent to that terminal of the simulation circuit which is to be connected to a live conductor (L).

3. Protection device according to Claim 1 or 2, **characterized in that** the semiconductor switch is a triac (TRIAC) the gate of which is controlled by a gate-control circuit (GCS), which is connected, via the test resistor (RTEST) and triac, to a zero-crossing (NDT) detector, the output signal from which activates the gate-control circuit (GCS), and **in that** the deactivation of the gate-control circuit is controlled by the time-control circuit (DT).

4. Protection device according to Claim 1 or 2, **characterized in that** the semiconductor switch is a thyristor (THI) which, via a rectifier circuit (GS), is incorporated in the fault current simulation circuit and is activated by actuation of the test switch (S1), and **in that** the control input of the thyristor is triggered by the time-control circuit (OS).

5. Protection device according to Claim 4, **characterized in that** the gate of the thyristor is controlled by pulses from the output of the rectifier circuit (GS), the amplitudes of which pulses decrease with time in accordance with a predetermined curve.

6. Protection device according to Claim 4 or 5, **characterized in that** the rectifier circuit is a full-wave so-called Graetz rectifier (D1-D4), the input of which is incorporated in the fault current simulation circuit and to the output of which the series circuit of the test resistor (RTEST) and the anode-cathode path is connected, **in that** the time-control circuit consists of a series circuit, which is connected to the output of the full-wave rectifier, comprising a first resistor (R1), a first capacitor (C1), a second resistor (R2), a first zener diode (D5) and a parallel circuit comprising a third resistor (R3) and a capacitor (C2), and of a parallel circuit comprising a fourth resistor (R4) and a second zener diode (D6), which parallel circuit is connected between the connection point of the first resistor (R1) and the first capacitor (C1) and the full-wave-circuit output, which is connected to the third resistor (R3) and the second capacitor (C2), the control input of the thyristor being connected to the connection point of the zener diode (D5) and the parallel circuit comprising the third resistor (R3) and second capacitor (C2).

## Patentansprüche

1. Schutzvorrichtung, vorgesehen zusammen mit einer Testschaltung zum Testen eines Fehlerstroms, wobei Folgendes vorgesehen ist:
Ein Testschalter (S1) und eine Fehlerstromsimulationsschaltung, die mittels des Testschalters eingeschaltet werden kann und in der ein Testwiderstand (R TEST) eingebaut ist und ferner mit einer Zeitsteuerschaltung (DT; OS; C1, R2) die die Fehlerstromsimulationsschaltung am Ende einer vorbestimmten Zeit, nachdem die Fehlerstromsimulationsschaltung eingeschaltet wurde, wieder ausschaltet, **dadurch gekennzeichnet, dass** der Schaltpfad eines Halbleiterschalters (TRIAC; TH1), der durch den Testschalter (S1) und direkt durch eine elektronische Zeitsteuerschaltung (DT; OS; C1, R2) ausgelöst wird, in die Fehlerstromsimulationsschaltung eingebaut ist.

2. Schutzvorrichtung nach Anspruch 1, **dadurch gekennzeichnet, dass** der Testschalter (S1) in die Fehlerstromsimulationsschaltung benachbart zu demjenigen Anschluss der Simulierschaltung eingebaut ist, der mit einem aktiven Leiter (L) zu verbinden ist.

3. Schutzvorrichtung nach Anspruch 1 oder 2, **dadurch gekennzeichnet, dass** der Halbleiterschalter ein Triac (TRIAC) ist, dessen Gate durch eine Gatesteuerschaltung (GCS) gesteuert wird, welche über den Testwiderstand (RTEST) und das Triac mit einem Nulldurchgangs-(NDT)-Detektor verbunden ist, wobei dessen Ausgangssignal die Gatesteuerschaltung (GCS) aktiviert und ferner **dadurch gekennzeichnet, dass** die Deaktivierung der Gatesteuerschaltung durch die Zeitsteuerschaltung (DT) gesteuert bzw. geregelt ist.

4. Schutzvorrichtung nach Anspruch 1 oder 2, **dadurch gekennzeichnet, dass** der Halbleiterschalter ein Thyristor (THI) ist, der über eine Gleichrichterschaltung (GS) in der Fehlerstromsimulationsschaltung eingebaut ist und aktiviert wird durch Betätigung des Testschalters (S1) und ferner
**dadurch gekennzeichnet, dass** der Steuereingang des Thyristors durch die Zeitsteuerschaltung (OS) ausgelöst wird.

5. Schutzvorrichtung nach Anspruch 4, **dadurch gekennzeichnet, dass** das Gate des Thyristors durch Impulse vom Ausgang der Gleichrichterschaltung (GS) gesteuert wird, wobei die Amplituden der Impulse mit der Zeit entsprechend einer vorbestimmten Kurve abnehmen.

6. Schutzvorrichtung nach Anspruch 4 oder 5, **dadurch gekennzeichnet, dass** die Gleichrichterschaltung ein Vollwellen sogenannter Graetz-Gleichrichter (D1 - D4) ist, dessen Eingang in die Fehlerstromsimulationsschaltung eingebaut ist, und wobei mit dem Ausgang des Gleichrichters die Serienschaltung des Testwiderstandes (RTEST) und des Anodenpfads verbunden ist, ferner **dadurch gekennzeichnet, dass** die Zeitsteuerschaltung aus einer Serienschaltung besteht, die mit dem Ausgang des Vollwellengleichrichters verbunden ist und einen ersten Widerstand (R1), einen ersten Kondensator (C1), einen zweiten Widerstand (R2), eine erste Zener-Diode (D5) und eine Parallelschaltung aufweist, die einen dritten Widerstand (R3) und einen Kondensator (C2) aufweist, und
wobei die Zeitsteuerschaltung ferner eine Parallelschaltung aufweist, und zwar bestehend aus einem vierten Widerstand (R4) und einer zweiten Zener-Diode (D6), wobei diese Parallelschaltung zwischen dem Verbindungspunkt des ersten Widerstandes (R1) mit dem ersten Kondensator (C1) und dem Vollwellenschaltungsausgang liegt, der mit dem dritten Widerstand (R3) und dem zweiten Kondensator (C2) verbunden ist, wobei der Steuereingang des Thyristors mit dem Verbindungspunkt der Zener-Diode (D5) und der Parallelschaltung bestehend aus drittem Widerstand (R3) und zweitem Kondensator (C2) verbunden ist.

## Revendications

1. Dispositif de protection muni d'un circuit de test destiné à tester un courant de défaut, comprenant un commutateur de test (S1) et un circuit de simulation de courant de défaut, qui peut être activé au moyen du commutateur de test et dans lequel une résistance de test (R TEST) est incorporée, et un circuit de temporisation (DT ; OS ; C1, R2), qui désactive le circuit de simulation de courant de défaut à la fin d'un temps prédéterminé après que le circuit de simulation de courant de défaut a été activé, **caractérisé en ce que** la ligne de commutation d'un commutateur à semiconducteur (TRIAC ; TH1), qui est déclenchée par le commutateur de test (S1) et directement par un circuit de temporisation électronique (DT ; OS ; C1, R2) est incorporée dans le circuit de simulation de courant de défaut.

2. Dispositif de protection selon la revendication 1, **caractérisé en ce que** le commutateur de test (S1) est incorporé dans le circuit de simulation de courant de défaut de façon adjacente à la borne du circuit de simulation qui doit être reliée à un conducteur sous tension (L).

3. Dispositif de protection selon la revendication 1 ou 2, **caractérisé en ce que** le commutateur à semiconducteur est un triac (TRIAC) dont la gâchette est commandée par un circuit de commande de gâchette (GCS), qui est relié, par l'intermédiaire de la résistance de test (RTEST) et du triac, à un détecteur de passage par zéro (NDT), dont le signal de sortie active le circuit de commande de gâchette (GCS), et **en ce que** la désactivation du circuit de commande de gâchette est commandée par le circuit de temporisation (DT).

4. Dispositif de protection selon la revendication 1 ou 2, **caractérisé en ce que** le commutateur à semiconducteur est un thyristor (THI) qui, par l'intermédiaire d'un circuit redresseur (GS), est incorporé dans le circuit de simulation de courant de défaut et est activé par l'actionnement du commutateur de test (S1), et **en ce que** l'entrée de commande du thyristor est déclenchée par le circuit de temporisation (OS).

5. Dispositif de protection selon la revendication 4, **caractérisé en ce que** la gâchette du thyristor est commandée par des impulsions provenant de la sortie du circuit redresseur (GS), impulsions dont les amplitudes diminuent dans le temps conformément à une courbe prédéterminée.

6. Dispositif de protection selon la revendication 4 ou 5, **caractérisé en ce que** le circuit redresseur est un redresseur de Graetz dit à double alternance (D1-D4), dont l'entrée est incorporée dans le circuit de simulation de courant de défaut et à la sortie duquel le circuit série de la résistance de test (RTEST) et de la ligne anode-cathode est relié, **en ce que** le circuit de temporisation est constitué d'un circuit série, lequel est relié à la sortie du redresseur à double alternance, comprenant une première résistance (R1), un premier condensateur (C1), une seconde résistance (R2), une première diode Zener (d5) et un circuit parallèle constitué d'une troisième résistance (R3) et d'un condensateur (C2), et d'un circuit parallèle comprenant une quatrième résistance (R4) et une seconde diode Zener (D6), lequel circuit parallèle est relié entre le point de connexion de la première résistance (R1) et du premier condensateur (C1) et la sortie du circuit à double alternance, laquelle est reliée à la troisième résistance (R3) et au second condensateur (C2), l'entrée de commande du thyristor étant reliée au point de connexion de la diode Zener (D5) et du circuit parallèle comprenant la troisième résistance (R3) et le second condensateur (C2).
